# EUROPEAN PATENT APPLICATION

(11) **EP 4 685 610 A1**
(43) Date of publication of application: **28.01.2026**
(21) Application number: 25191182.2
(22) Date of filing: 23.07.2025
(51) Int. Cl.: G06F 1/16

(54) **DISPLAY DEVICE**

(30) Priority: 25.07.2024 KR 20240098593
(71) Applicant: LG Electronics Inc., Yeongdeungpo-gu Seoul 07336 (KR)
(72) Inventor: KANG, Seunggyu, Seoul (KR); PYO, Jonggil, Seoul (KR)
(74) Representative: Schornack, Oliver

(57) **Abstract**

The display device includes: a display panel which displays an image and has light transmission properties; a transparent panel facing the display panel; a side frame which extends along a lateral side of the display panel, and is coupled to the transparent panel; a belt which is embedded in the side frame; a bar which extends in a direction intersecting with the side frame, and has one end fixed to the belt; a roller which is adjacent to a lower side connected to the lateral side of the display panel; a light shielding film which has one end fixed to the bar; a rear frame which is positioned opposite to the transparent panel with respect to the light shielding film; an upper pulley which is positioned above the side frame; a drive pulley; and a sub pulley.

## Description

### TECHNICAL FIELD

This disclosure relates to display device, and more particularly, to a display device having a transparent display panel.

### BACKGROUND

As the information society develops, the demand for display devices is also increasing in various forms, and in response to this, various display devices such as Liquid Crystal Display Device (LCD), Plasma Display Panel (PDP), Electro luminescent Display (ELD), Vacuum Fluorescent Display (VFD), and Organic Light Emitting Diode (OLED) have been studied and used recently.

Among these, the LCD panel has a TFT substrate and a color substrate that are opposite to each other with a liquid crystal layer interposed therebetween, and may display images by using light provided from a backlight unit. In addition, an OLED panel may display images by depositing an organic layer that can emit light naturally on a substrate on which a transparent electrode is formed.

Recently, much research has been conducted on transparent display panels that can not only display an image to a user, but also allow a user to see the back of a display panel.

### SUMMARY

The disclosure has been made in view of the above problems, and may provide a display device having a transparent display panel.

The disclosure may further provide a structure and a driving mechanism for opening and closing the rear surface of a transparent display panel.

The disclosure may further provide a frame structure in which a transparent display panel and a light shielding film are coupled.

The disclosure may further provide a frame structure that maintains the left and right levels of a light shielding film to be equal and supports the bottom dead center of the light shielding film.

The disclosure may further provide a frame structure that covers a roller around which a light shielding film is wound or that support the light shielding film.

The disclosure may further provide a mechanism that can increase the service life of a belt.

In accordance with an aspect of the present disclosure, a display device includes: a display panel which displays an image and has light transmission properties; a transparent panel facing the display panel; a side frame which extends along a lateral side of the display panel, and is coupled to the transparent panel; a belt which is embedded in the side frame, and moves along a length direction of the side frame; a bar which extends in a direction intersecting with the side frame, and has one end fixed to the belt; a roller which is adjacent to a lower side connected to the lateral side of the display panel, and extends along the lower side of the display panel and is rotatable; a light shielding film which has one end fixed to the bar, has the other end coupled to the roller, and is wound around or unwound from the roller when the bar moves; a rear frame which is positioned opposite to the transparent panel with respect to the light shielding film; an upper pulley which is positioned above the side frame, and around which the belt is wound; a drive pulley which is mounted on the rear frame, faces the light shielding film, rotates about an axis that is a thickness direction of the light shielding film, and around which the belt is wound; and a sub pulley which is positioned between the drive pulley and the bar, is mounted on the rear frame while being adjacent to the drive pulley, and pushes the belt.

### BRIEF DESCRIPTION OF THE DRAWINGS

The above and other objects, features and advantages of the present disclosure will be more apparent from the following detailed description in conjunction with the accompanying drawings, in which:

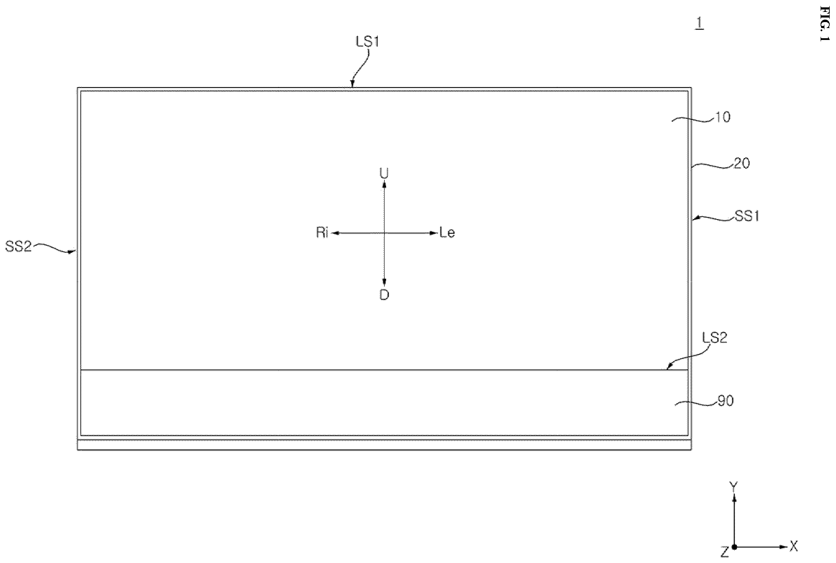

FIGS. 1 to 33 are drawings illustrating examples of a display device according to embodiments of the present disclosure.

### DETAILED DESCRIPTION

Description will now be given in detail according to exemplary embodiments disclosed herein, with reference to the accompanying drawings. For the sake of brief description with reference to the drawings, the same or equivalent components may be denoted by the same reference numbers, and description thereof will not be repeated.

In general, suffixes such as "module" and "unit" may be used to refer to elements or components. Use of such suffixes herein is merely intended to facilitate description of the specification, and the suffixes do not have any special meaning or function.

In the present disclosure, that which is well known to one of ordinary skill in the relevant art has generally been omitted for the sake of brevity. The accompanying drawings are used to assist in easy understanding of various technical features and it should be understood that the embodiments presented herein are not limited by the accompanying drawings. As such, the present disclosure should be construed to extend to any alterations, equivalents and substitutes in addition to those which are particularly set out in the accompanying drawings.

It will be understood that although the terms first, second, etc. may be used herein to describe various elements, these elements should not be limited by these terms. These terms are only used to distinguish one element from another.

It will be understood that when an element is referred to as being "connected with" another element, there may be intervening elements present. In contrast, it will be understood that when an element is referred to as being "directly connected with" another element, there are no intervening elements present.

A singular representation may include a plural representation unless context clearly indicates otherwise.

In the present application, it should be understood that the terms "comprises, includes," "has," etc. specify the presence of features, numbers, steps, operations, elements, components, or combinations thereof described in the specification, but do not preclude the presence or addition of one or more other features, numbers, steps, operations, elements, components, or combinations thereof.

The direction indications of up U, down D, left Le, right Ri, front F, and rear R shown in the drawings are only for the convenience of explanation, and the technical concepts disclosed in this specification are not limited thereby.

Referring to FIG. 1, a display device 1 may include a display 10, a side frame 20, and a housing 90. The display 10 may display an image. The side frame 20 may extend along a perimeter of the display 10. The housing 90 may be positioned below the display 10 and the side frame 20. Alternatively, the housing 90 may be positioned above, in the left side of, or below the display 10 and the side frame 20.

The display 10 may include a first long side LS1, a second long side LS2 opposite to the first long side LS1, a first short side SS1 adjacent to the first long side LS1 and the second long side LS2, and a second short side SS2 opposite to the first short side SS1.

Meanwhile, for convenience of explanation, it is illustrated that the lengths of the first and second long sides LS1 and LS2 are longer than the lengths of the first and second short sides SS1 and SS2, but it may be possible that the lengths of the first and second long sides LS1 and LS2 are approximately the same as or longer than the lengths of the first and second short sides SS1 and SS2.

The direction parallel to the long sides LS1 and LS2 of the display 10 may be referred to as a left-right direction. The direction parallel to the short sides SS1 and SS2 of the display 10 may be referred to as an up-down direction. The direction perpendicular to the long sides LS1, LS2 and short sides SS1, SS2 of the display 10 may be referred to as a front-rear direction.

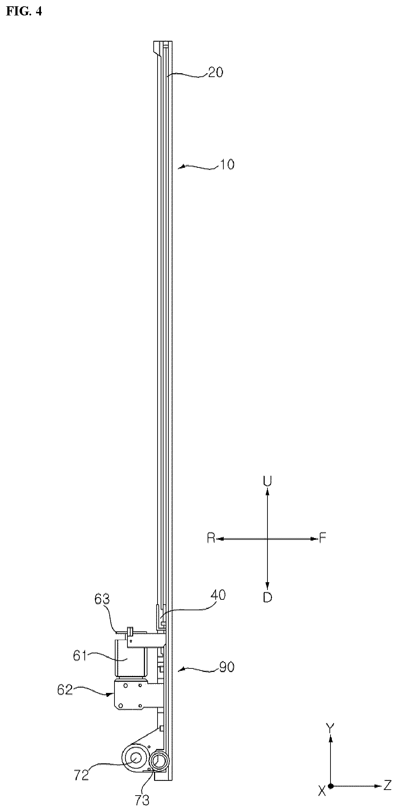

The direction in which the display 10 displays an image may be referred to as a forward direction (F, z)(see FIG. 4), and the opposite direction may be referred to as a rearward direction (R, -z)(see FIG. 4). The side of the first short side SS1 may be referred to as a left (Le, x). The side of second short side SS2 may be referred to as a right (Ri, -x). The side of first long side LS1 may be referred to as an upper side (U, y). The side of second long side LS2 may be referred to as a lower side (D, -y).

Hereinafter, a display panel using an organic light emitting diode (OLED) is described as an example, but the display panel applicable to the present disclosure is not limited thereto.

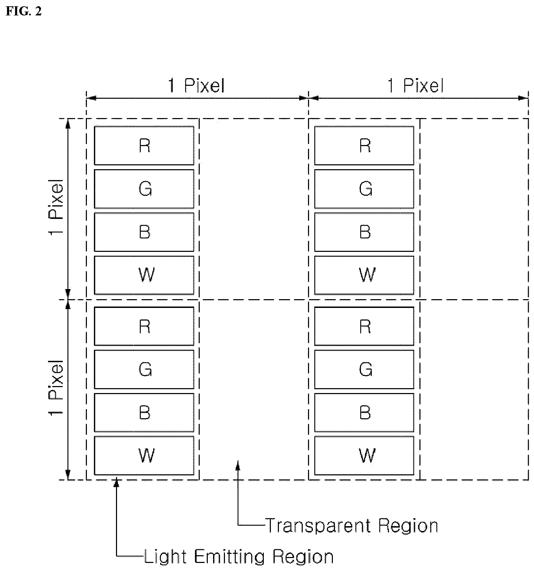

Referring to FIG. 2, a pixel may include a light emitting region and a transparent region. In the light emitting region, subpixels of Red, Green, Blue, White (RGBW) may be arranged in a length direction, and the transparent region having no subpixel may be arranged next to the light emitting region.

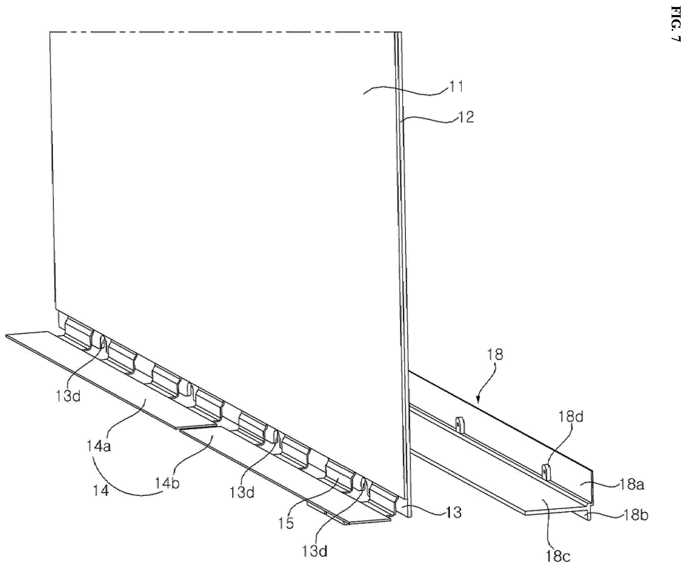

Accordingly, a display panel 11 (see FIG. 7) having a plurality of pixels may display an image as well as transmit light. The display panel 11 (see FIG. 7) may be referred to as a transparent display panel or a transparent OLED panel.

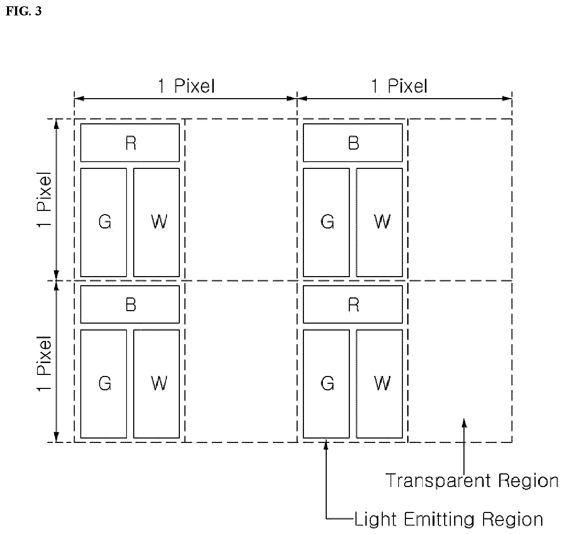

Referring to FIG. 3, a pixel may include a light emitting region and a transparent region. In the light emitting region, subpixels of RGW Red, Green, White or BGW Blue, Green, White may be arranged adjacent to each other, and the light emitting region without subpixels may be arranged next to the light emitting region.

Accordingly, the display panel 11 (see FIG. 7) having a plurality of pixels may display an image as well as transmit light. The display panel 11 (see FIG. 7) may be referred to as a transparent display panel or a transparent OLED panel.

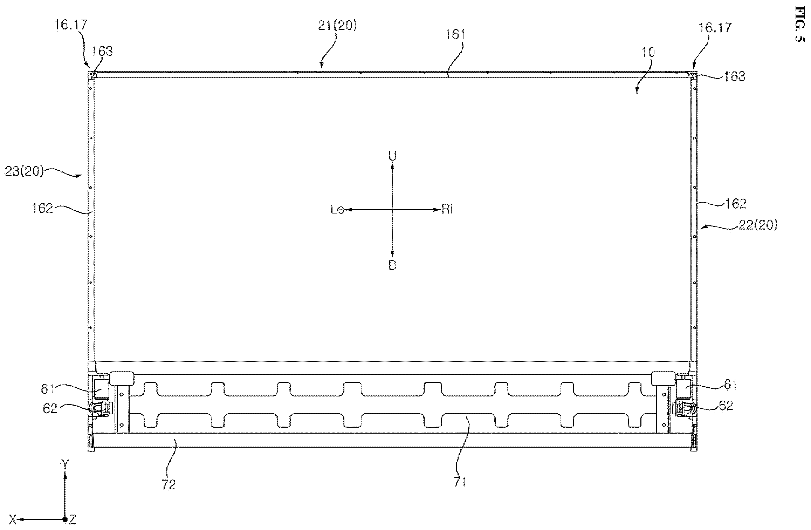

Referring to FIGS. 4 and 5, the display 10 may be coupled to the side frame 20. A housing frame 71 may be coupled or fixed to the side frame 20. The housing frame 71 may cover the rear surface of the display 10. The housing frame 71 may be positioned behind the display 10. The housing frame 71 may be referred to as a rear frame 71 or a rear plate 71 or a rear base 71. The length of the housing frame 71 may correspond to the length of the long side LS1, LS2 (see FIG. 1) of the display 10. The width of the housing frame 71 may be shorter than the length of the short side of the display 10.

There may be a plurality of motors 61. Each of the plurality of motors 61 may be adjacent to the left and right sides of the display 10 and arranged behind the display 10. A pair of motors 61 may provide dual driving force. A gear box 62 may correspond to the motor 61. Each of a plurality of gear boxes 62 may be connected to each of the plurality of motors 61. The dual driving force provided by the pair of motors 61 may be transmitted by the pair of gear boxes 62. The motor 61 and/or the gear box 62 may be coupled to or fixed to the rear surface of the housing frame 71. The motor 61 and/or the gear box 62 may not be exposed to the front of the display device 1 by the housing frame 71. A bar 40 may slide in the up-down direction on the side frame 20.

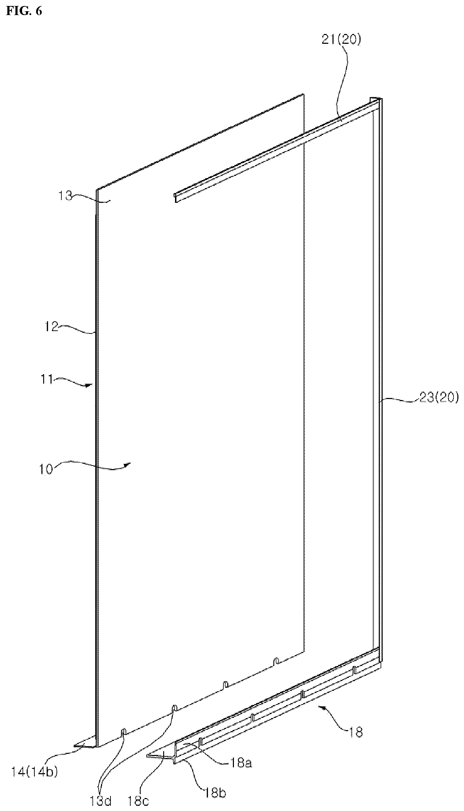

Referring to FIG. 6 together with FIG. 5, the display 10 may be coupled to the side frame 20. A lower frame 18 may be coupled or fixed to the side frame 20, and may support the display 10 at the lower side of the display 10. The side frame 20 may include a first part 21, a second part 22, and a third part 23.

The first part 21 may be coupled to the upper side of the display 10, the second part 22 may be coupled to the right side of the display 10, and the third part 23 may be coupled to the left side of the display 10. The lower frame 18 may be coupled or fixed to the second part 22 and/or the third part 23 of the side frame 20. Each of vertical fixers 162 may be coupled to each of the second part 22 and the third part 23, and a horizontal fixer 161 may be coupled to the first part 21. A corner fixer 16 and a pulley 17 may be coupled to the vertical fixer 162 and/or the horizontal fixer 161 at an upper corner.

Referring to FIG. 7 together with FIG. 6, the display panel 11 may output an image by dividing an image into a plurality of pixels and adjusting the color, brightness, and saturation for each pixel. The display panel 11 may be divided into an active area AA where an image is displayed and a de-active area DA where an image is not displayed. The display panel 11 may generate light corresponding to the color of red, green, or blue according to a control signal.

A source PCB 14 may be adjacent to the lower side of the display panel 11. The source PCB 14 may extend along the lower side of the display panel 11. The source PCB 14 may be electrically connected to the display panel 11 through a Chip On Film (COF) 15. The source PCB 14 may be electrically connected to a timing controller board (T-CON board) through a cable (not shown) such as a Flexible Flat Cable (FFC).

A transparent panel 13 may be positioned in front of the display panel 11. The transparent panel 13 may be glass of a transparent material. An adhesive film 12 may be positioned between the display panel 11 and the transparent panel 13, and may be coupled to the display panel 11 and the transparent panel 13. The adhesive film 12 may be an Optically Clear Adhesive Film (OCA film). The transparent panel 13 may be referred to as a front panel 13.

The adhesive film 12 may cover at least a part of the rear surface of the transparent panel 13. For example, one side of the adhesive film 12 may be positioned closer to the center of the display panel 11 than one side of a corresponding transparent panel 13. The size or area of the adhesive film 12 may be smaller than the size or area of the transparent panel 13. For example, the upper side, the left side, and the right side of the adhesive film 12 may be adjacent to the upper side, the left side, and the right side of the transparent panel 13, respectively, and the lower side of the adhesive film 12 may be spaced upward from the lower side of the transparent panel 13.

The size of the adhesive film 12 may correspond to the size of the display panel 11. For example, the diagonal length of the adhesive film 12 may be substantially the same as the diagonal length of the display panel 11. For another example, the diagonal length of the adhesive film 12 may be longer than the diagonal length of the display panel 11. A part of the adhesive film 12 may be arranged along the perimeter of the display panel 11 on the outside of the display panel 11. For example, the adhesive film 12 may form a square line along the perimeter of the display panel 11.

The display panel 11, the adhesive film 12, and the transparent panel 13 may be referred to as a display 10.

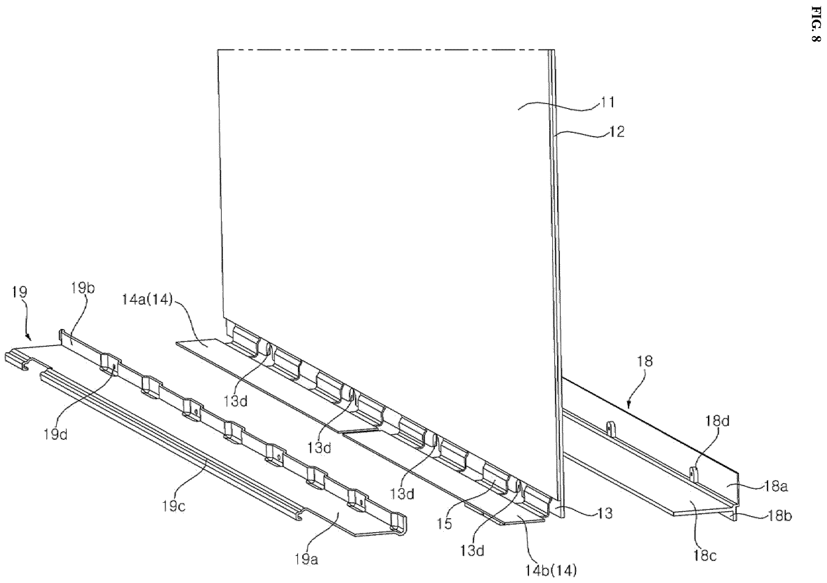

Referring to FIG. 8 together with FIG. 7, the lower frame 18 may include a horizontal portion 18c, a first vertical portion 18a, a second vertical portion 18b, and a coupling portion 18d. The horizontal portion 18c may be a long extended plate, and the first vertical portion 18a may extend upward from the front edge of the horizontal portion 18c to form a right angle with the horizontal portion 18c. The second vertical portion 18b may extend downward from the front edge of the horizontal portion 18c to form a right angle with the horizontal portion 18c. The coupling portion 18d may protrude from the rear surface of the first vertical portion 18a. The coupling portion 18d may be formed on the upper surface of the horizontal portion 18c and/or the rear surface of the first vertical portion 18a. A plurality of coupling portions 18d may be arranged at regular intervals.

The transparent panel 13 may have a coupling groove 13d partially deleted from the lower side. The coupling groove 13d of the transparent panel 13 may correspond to the coupling portion 18d of the lower frame 18. The coupling portion 18d of the lower frame 18 may be inserted into the coupling groove 13d of the transparent panel 13. The first vertical portion 18a may cover the front surface of the transparent panel 13 adjacent to the lower side of the transparent panel 13. The horizontal portion 18c of the lower frame 18 may support the transparent panel 13.

The source PCB 14 may be positioned on the horizontal portion 18c of the lower frame 18. The source PCB 14 may face or be in contact with the horizontal portion 18c of the lower frame 18.

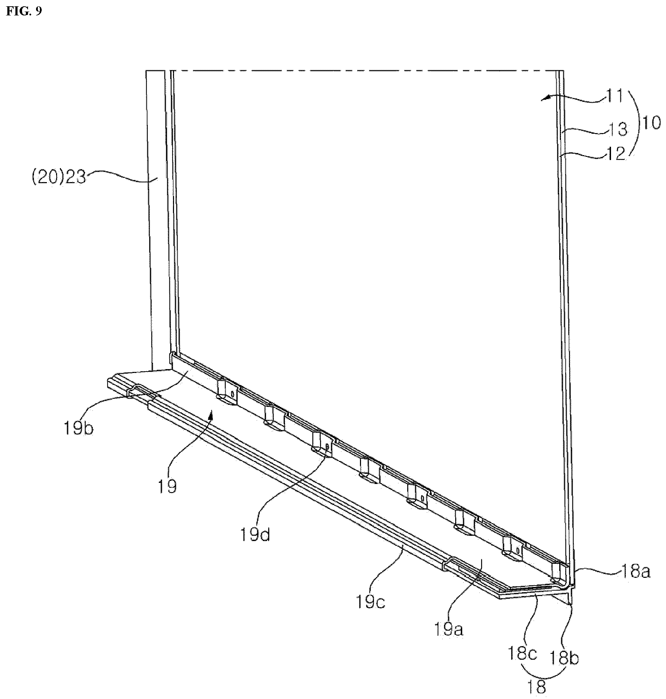

Referring to FIG. 9 together with FIG. 8, the PCB cover 19 may include a horizontal portion 19a, a folding portion 19c, a vertical portion 19b, and a fixing portion 19d. The horizontal portion 19a may be a long extended plate, and may cover the source PCB 14. The vertical portion 19b may be formed to extend upward or bend from an edge of the horizontal portion 19a. The folding portion 19c may be opposite to the vertical portion 19b with respect to the horizontal portion 19a. The folding portion 19c may extend from the horizontal portion 19a while bending toward the lower surface of the horizontal portion 19a. The folding portion 19c may face the horizontal portion 19a. The fixing portion 19d may be formed in the vertical portion 19b. The fixing portion 19d may be formed by protruding in a forward direction of the vertical portion 19b as the vertical portion 19b is pressed. The fixed portion 19d may be fixed to the coupling portion 18d of the lower frame 18.

When the folding portion 19c of the PCB cover 19 is coupled to the horizontal portion 18c of the lower frame 18, and when the fixing portion 19d of the PCB cover 19 is fixed to the coupling portion 18d of the lower frame 18, the PCB cover 19 may cover the source PCB 14.

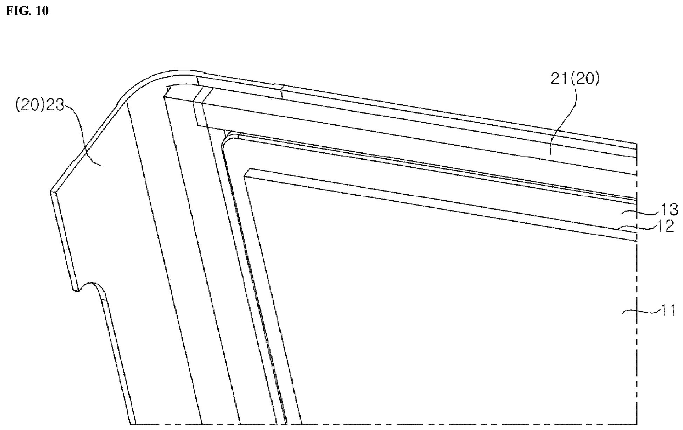

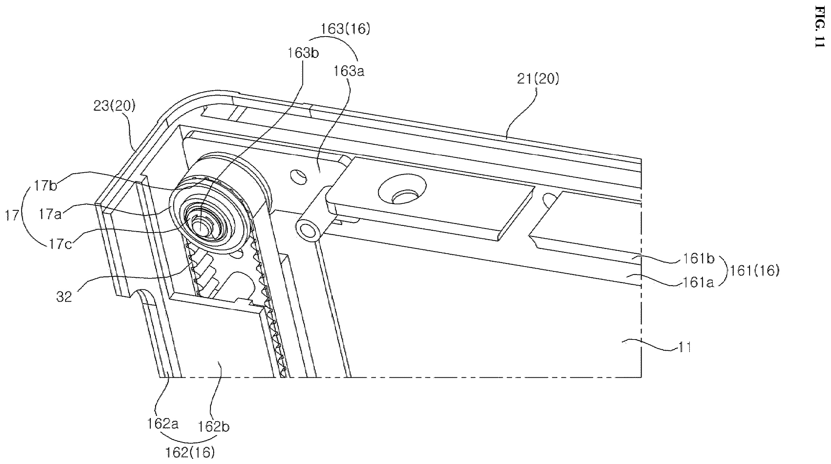

Referring to FIGS. 10 and 11, the display panel 11 may be disposed on the rear surface of the transparent panel 13. The display panel 11 may be adhered to or fixed to the adhesive film 12.

The frame fixer 16 may include a horizontal fixer 161, a vertical fixer 162, and a corner fixer 163. The horizontal fixer 161 may be formed with the vertical fixer 162 as one body. The horizontal fixer 161 and the vertical fixer 162 may be referred to as inner frames 161, 162. The horizontal fixer 161 may include a plate 161a and a wall 161b. The plate 161a may be extended long in the left-right direction, and may be fixed to the first part 21 of the side frame 20. The wall 161b may be formed on the plate 161a. The wall 161b may protrude in a rearward direction from the outer surface of the plate 161a.

The vertical fixer 162 may include a plate 162a and a wall 162b. The plate 162a may be extended long in the up-down direction, and may be fixed to the third part 23 of the side frame 20. The wall 162b may be formed on the plate 162a. The wall 162b may protrude in the left-right direction from the outer surface of the plate 162a.

The corner fixer 163 may be a curved plate segment. The corner fixer 163 may be a plate 163a curved along the corner of the vertical fixer 162 and the horizontal fixer 161. A pulley shaft 163b may extend from the outer surface of the plate 163a of the corner fixer 163 toward the rear of the transparent panel 13. The corner fixer 163 may be adhered or fixed to the horizontal fixer 161 and/or the vertical fixer 162. The corner fixer 163 may be referred to as a left corner fixer 163 or a first corner fixer 163. When the corner fixer 163 is positioned at the corner formed by the first part 21 and the second part 22 of the side frame 20 (see FIG. 5), the corner fixer 163 may be referred to as a right corner fixer 163 or a second corner fixer 163.

The pulley 17 may be inserted onto the pulley shaft 163b. The pulley 17 may rotate on the pulley shaft 163b. The pulley 17 may be referred to as an upper pulley 17. For example, a lubricant may be applied between the pulley shaft 163b and the pulley 17 to prevent noise. For another example, the pulley 17 may be formed of a synthetic resin having low frictional resistance, and the pulley shaft 163b may include metal and prevent noise and smoothly rotate the pulley 17. A belt 32 may be wound around the pulley 17.

The pulley 17 may include a wheel 17a and a belt gear 17b. The wheel 17a may be formed in a ring or rim shape. The pulley shaft 163b may be inserted into the wheel 17a, and the wheel 17a may rotate on the pulley shaft 163b. The belt gear 17b may form the outer surface of the wheel 17a. A fixing washer 17c may be adjacent to the distal end of the pulley shaft 163b and coupled to the pulley shaft 163b. For example, the fixing washer 17c may be an E-ring. The fixing washer 17c may prevent the pulley 17 from being separated from the pulley shaft 163b. A first pulley 17 or a left pulley 17 may be positioned at a first corner fixer 163 or a left corner fixer 163, and a second pulley 17 (see FIG. 5) or a right pulley 17 (see FIG. 5) may be positioned at a second corner fixer 163 or a right corner fixer 163.

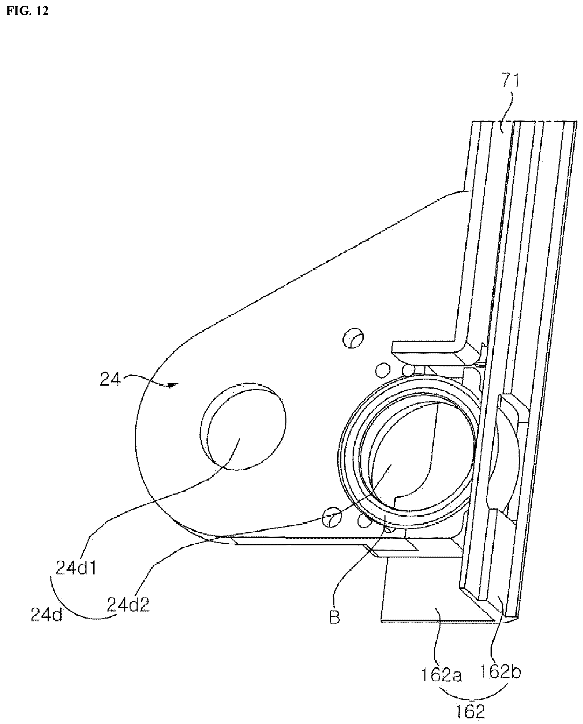

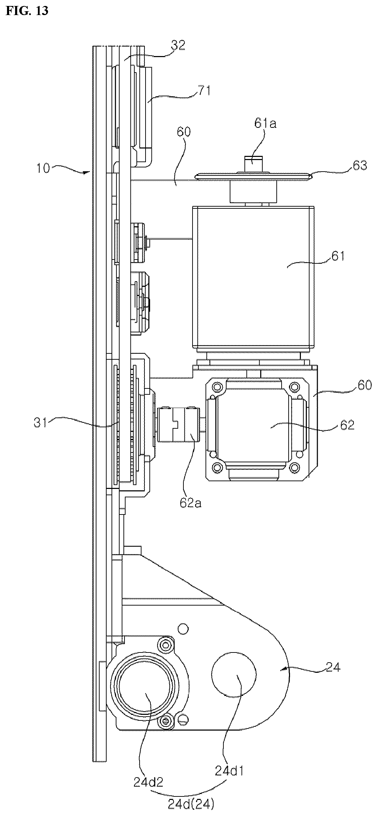

Referring to FIGS. 12 and 13, a mount bracket 24 may be coupled or fixed to the plate 162a of the vertical fixer 162, and supported by the wall 162b of the vertical fixer 162. The mount bracket 24 may be coupled or fixed to the wall 162b of the vertical fixer 162 and supported on the plate 162a of the vertical fixer 162.

The mount bracket 24 may include a main roller hole 24d1 and a sub roller hole 24d2. The sub roller hole 24d2 may face or overlap with the plate 162a of the vertical fixer 162. The main roller hole 24d1 may be adjacent to the sub roller hole 24d2. A bearing B may be mounted in the main roller hole 24d1 and/or the sub roller hole 24d2.

A fixed bracket 60 may be coupled to the vertical fixer 162 or coupled to the housing frame 71. The fixed bracket 60 may also be formed with the housing frame 71 as one body. The motor 61 and/or the gear box 62 may be coupled to the fixed bracket 60. The motor 61 may provide rotational force, and the gear box 62 may be connected to the motor 61 to transmit driving force. A rotation counter 63 may be fixed to a motor shaft 61a and may rotate together with the motor shaft 61a.

A joint 62a may be connected to the gear box 62 and may rotate by receiving driving force from the gear box 62. The axial direction of the joint 62a may be parallel to the thickness direction of the display 10. A drive pulley 31 may be fixed to the joint 62a and may rotate together with the joint 62a. The belt 32 may be wound around the drive pulley 31. The belt 32 may be referred to as a drive belt 32 or a timing belt 32. The drive pulley 31 may be referred to as a lower pulley 31, a main pulley 31, or a suspending pulley 31.

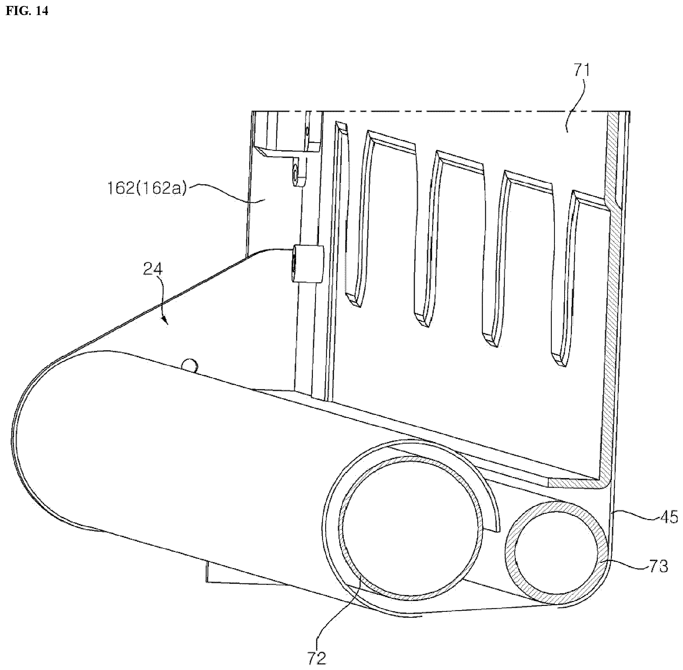

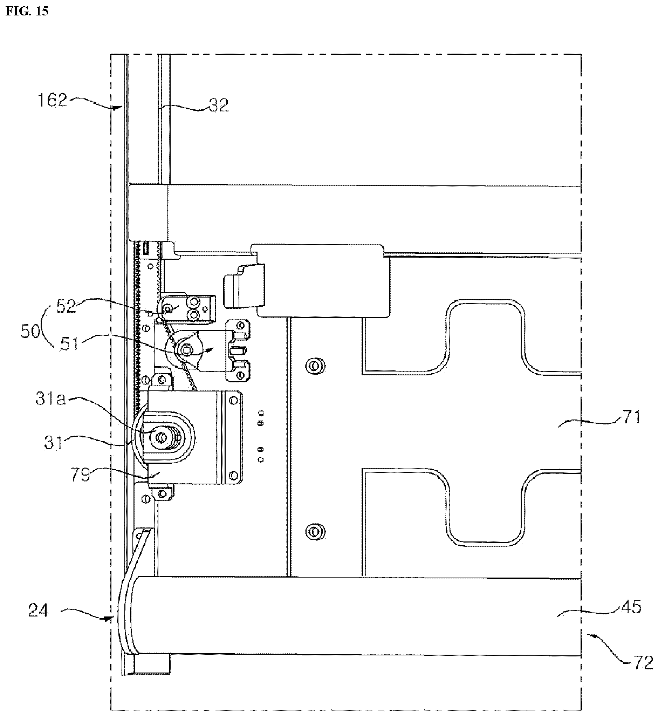

Referring to FIGS. 14 and 15, a main roller 72 may be coupled or inserted into a main roller hole 24d1 (see FIG. 13) of the mount bracket 24 and rotated. A sub roller 73 may be coupled or inserted into a sub roller hole 24d2 (see FIG. 13) of the mount bracket 24 and rotated. A light shielding film 45 may be wound around the main roller 72 and supported by the sub roller 73. The light shielding film 45 may be referred to as a light shielding layer 45. The light shielding film 45 may be guided by the sub roller 73 while being released from the main roller 72 and moved to the front surface of the housing frame 71. The light shielding film 45 released from the main roller 72 may cover the front surface of the housing frame 71.

The pulley mount 79 may be coupled to the rear surface of the housing frame 71. The pulley mount 79 may be a bracket or a plate. The pulley mount 79 may be formed with the housing frame 71 as one body. The drive pulley 31 may rotate in the pulley mount 79. A shaft 31a of the drive pulley 31 may be inserted into the pulley mount 79, and may be positionally aligned by the pulley mount 79. For example, the drive pulley 31 may rotate in the pulley mount 79, but may not move in the up-down direction or in the left-right direction.

A sub pulley 50 may be a tensioner 50. The sub pulley 50 may be positioned on the upper side of the pulley mount 79, and may push the belt 32. The belt 32 may maintain a certain tension by the sub pulley 50. There may be a plurality of sub pulleys 51, 52.

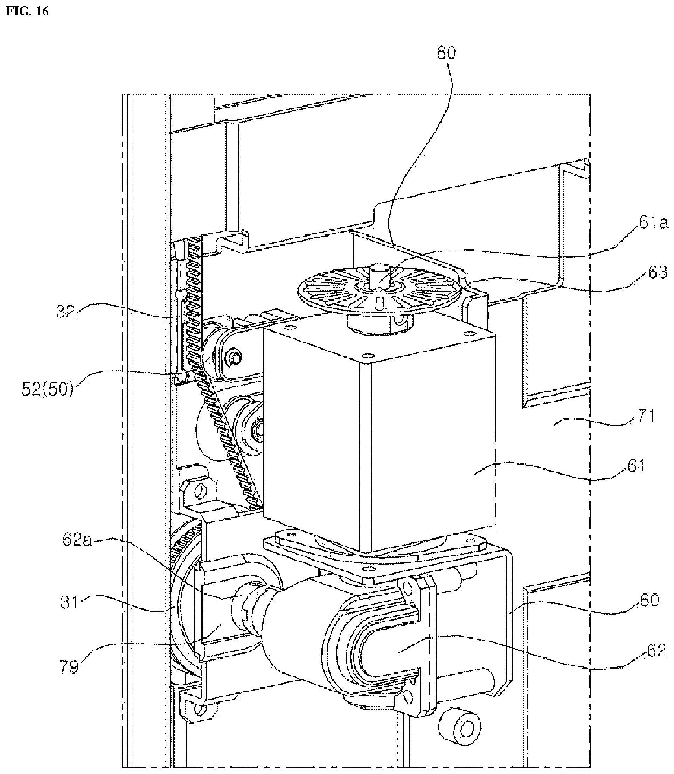

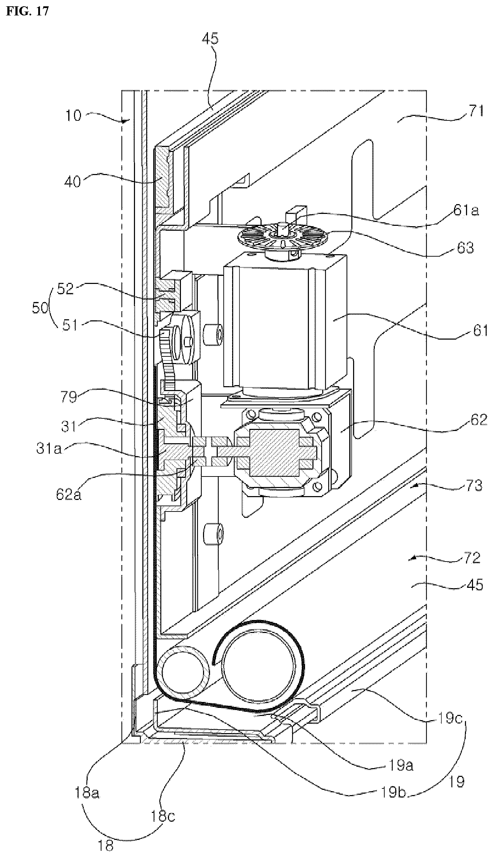

Referring to FIG. 16 and FIG. 17 together with FIG. 15, the driving force provided by the motor 61 may be transmitted to the drive pulley 31 through the gear box 62. The drive pulley 31 may rotate on the pulley mount 79. As the drive pulley 31 rotates, the belt 32 may move in the up-down direction, and the belt 32 may maintain a certain tension by the sub pulley 50.

The lower frame 18 to which the PCB cover 19 is coupled may be positioned on the lower side of the housing frame 71. The main roller 72 and the sub roller 73 may be positioned on the lower frame 18 and may be positioned behind the housing frame 71. The light shielding film 45 may be wound around and unwound from the main roller 72, and guided by the sub roller 73 to cover the front surface of the housing frame 71.

The distal end of the light shielding film 45 may be fixed to the bar 40. As the belt 32 fixed to one end of the bar 40 moves, the bar 40 may move in the up-down direction. As the bar 40 moves, the light shielding film 45 may cover the rear surface of the display 10. The bar 40 may be positioned behind the rear surface of the display 10, and may move in the up-down direction of the display 10.

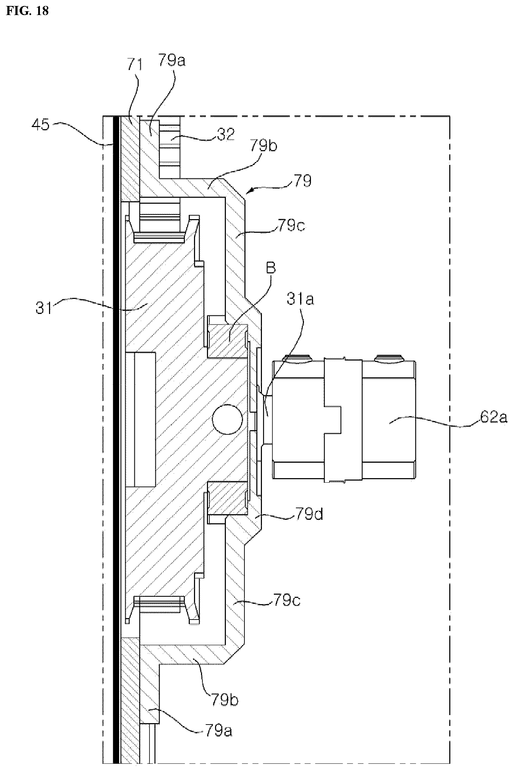

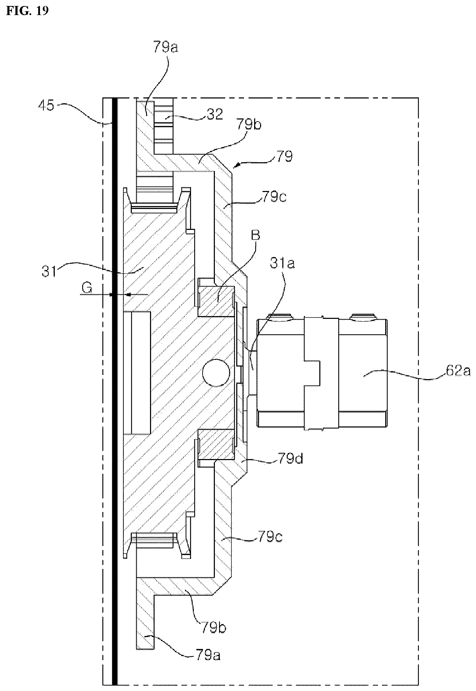

Referring to FIGS. 18 and 19, the pulley mount 79 may include a flange portion 79a, a pulley housing 79b, a bearing mount 79c, and a shaft mount 79d. The flange portion 79a may be fixed to the rear surface of the housing frame 71 in a disc shape. The pulley housing 79b may provide a space in which the drive pulley 31 is accommodated. The diameter of the pulley housing 79b may be larger than the diameter of the drive pulley 31, and the height of the pulley housing 79b may be larger than the thickness of the drive pulley 31.

The bearing B may be fixed to the bearing mount 79c. The pulley shaft 31a may penetrate from the inside to the outside of the pulley mount 79 through the shaft mount 79d. The drive pulley 31 may be coupled to the bearing B and may rotate inside the pulley housing 79b. The pulley shaft 31a may be coupled to the joint 62a and may rotate together with the joint 62a.

The front surface of the drive pulley 31 may be spaced from the light shielding film 45. A constant gap G can be formed between the front surface of the drive pulley 31 and the rear surface of the light shielding film 45. Accordingly, the belt 32 can be moved while the drive pulley 31 rotates without a structure penetrating the light shielding film 45.

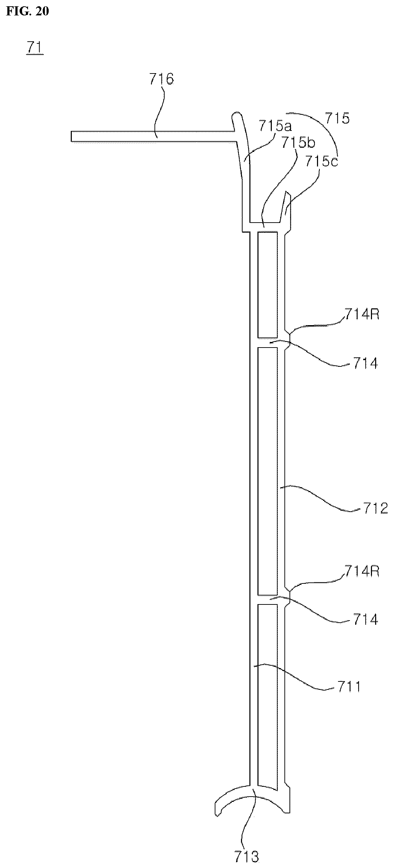

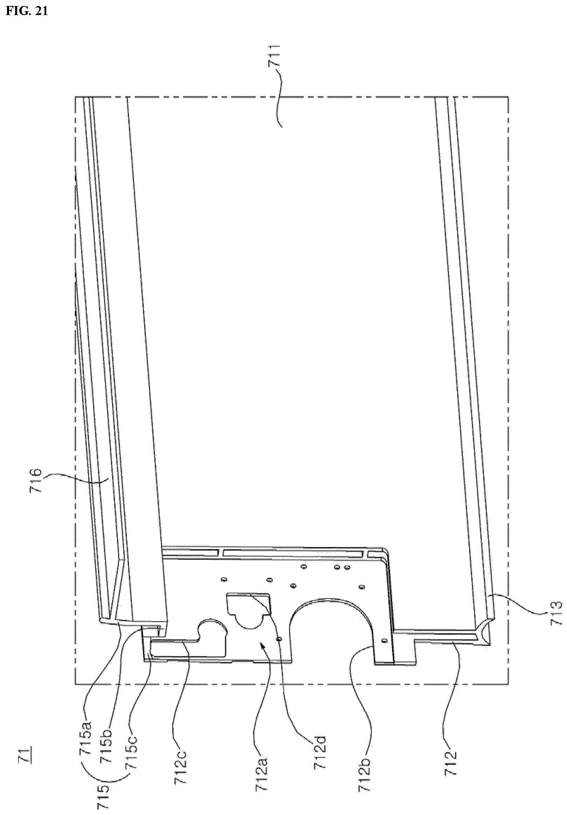

Referring to FIGS. 20 and 21, the housing frame 71 may include a front part 712, a rear part 711, an inner rib 714, a bar supporter 715, a top part 716, and a roller cover 713.

The front part 712 may face the rear part 711. The rear part 711 may be opposite to the front part 712. The inner rib 714 may connect the front part 712 and the rear part 711 at between the front part 712 and the rear part 711. A gap or space may be formed between the front part 712 and the rear part 711 by the inner rib 714. The housing frame 71 may further include an outer rib 714R. The outer rib 714R may be formed on the outer surface of the front part 712 in correspondence with the inner rib 714. There may be a plurality of outer ribs 714R, and the outer rib 714R may be extended in the left-right direction of the outer surface of the front part 712 of the housing frame 71. Each of the plurality of outer ribs 714R may correspond to or be aligned with each of the plurality of inner ribs 714.

The roller cover 713 may be positioned at the lower end of the front part 712 and the rear part 711. The roller cover 713 may connect the front part 712 and the rear part 711. The roller cover 713 may be a part of a cylinder shape. The center of curvature of the roller cover 713 may be opposite to the front part 712 and the rear part 711 with respect to the roller cover 713.

The bar supporter 715 may include a back supporter 715a, a bottom supporter 715b, and a front supporter 715c. For example, the bar supporter 715 may have an overall L shape. The front supporter 715c may be opposite to the back supporter 715a with respect to the bottom supporter 715b. The height of the back supporter 715a may be greater than the height of the front supporter 715c.

The top part 716 may be connected to the back supporter 715a. The top part 716 may be opposite to the roller cover 713 with respect to the front part 712 and/or the rear part 711.

The mount part 712a may be defined by the front part 712 that is exposed when the rear part 711 is cut. The rear part 711 and/or the inner rib 714 may be cut so that the rear surface of the front part 712 is exposed. The mount part 712a may include a plurality of cut-out portions 712b, 712c, 712d. A first cut portion 712b may be formed by cutting the side of the front part 712 while forming a bay. A second cut portion 712c and/or a third cut portion 712d may be formed by punching the front part 712. Accordingly, the torsional and/or bending rigidity of the housing frame 71 may be increased.

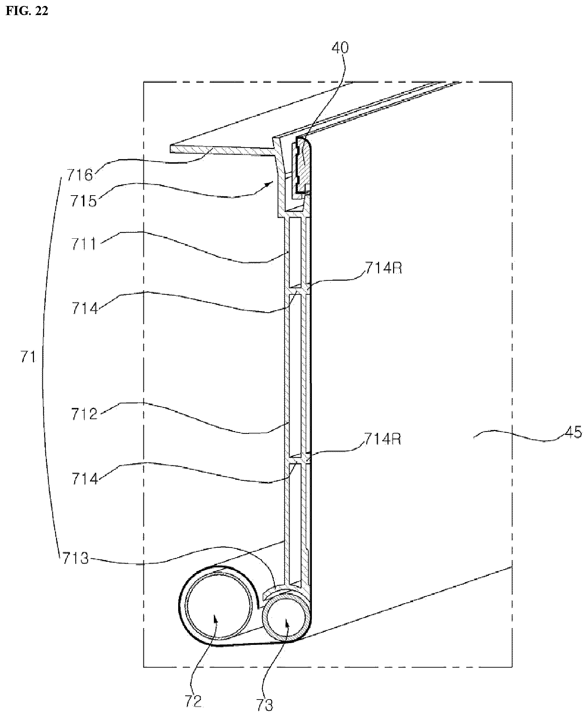

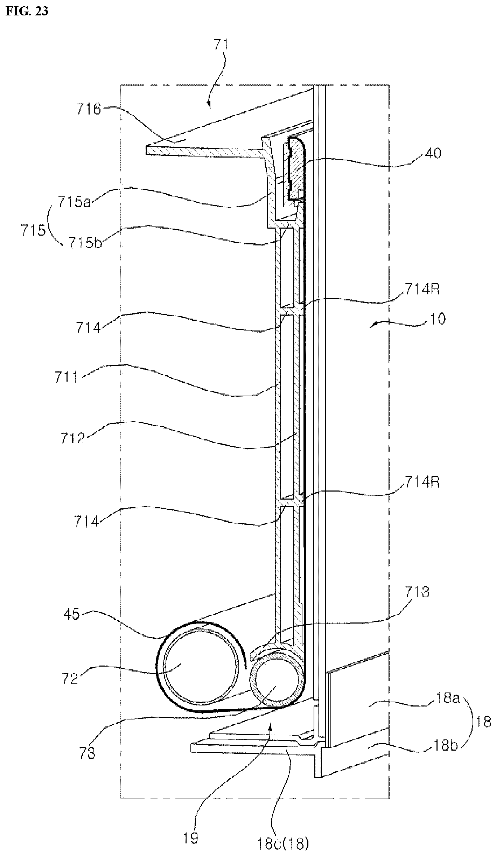

Referring to FIGS. 22 and 23, the sub roller 73 may be positioned below the roller cover 713. The roller cover 713 may cover the upper arc of the sub roller 73. The roller cover 713 may be spaced apart from the sub roller 73. The main roller 72 may be positioned at the rear of the housing frame 71 while being adjacent to the sub roller 73. The light shielding film 45 may be wound around the main roller 72, and supported by the sub roller 73. The light shielding film 45 may be unwound from the main roller 72, wrap around the sub roller 73, and cover the front part 712 of the housing frame 71. The light shielding film 45 may be coupled or fixed to the bar 40. The bar 40 may be positioned on the bar supporter 715. When the bar 40 is positioned on the bar supporter 715, the bar 40 may be positioned at the bottom dead center.

The display 10 may be opposite to the housing frame 71 with respect to the light shielding film 45. The display 10 may face the light shielding film 45 and/or the front part 712 of the housing frame 71. The bar 40 may be positioned adjacent to the rear surface of the display 10.

The main roller 72 and/or the sub roller 73 may be positioned on the lower frame 18. The main roller 72 and/or the sub roller 73 may be spaced from the lower frame 18 and/or the PCB cover 19. The vertical portion 18a of the lower frame 18 may cover the front of the sub roller 73. The light shielding film 45 that is unwound from the main roller 72 and winds around the sub roller 73 may be covered by the vertical portion 18a of the lower frame 18.

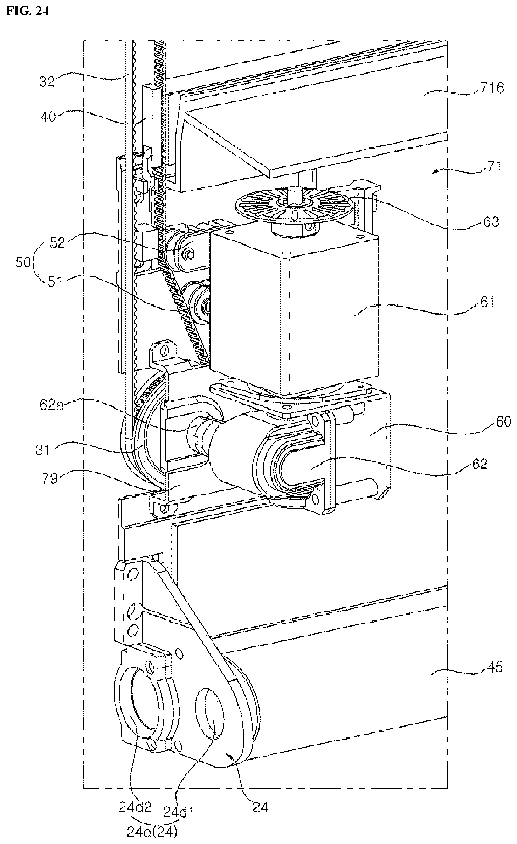

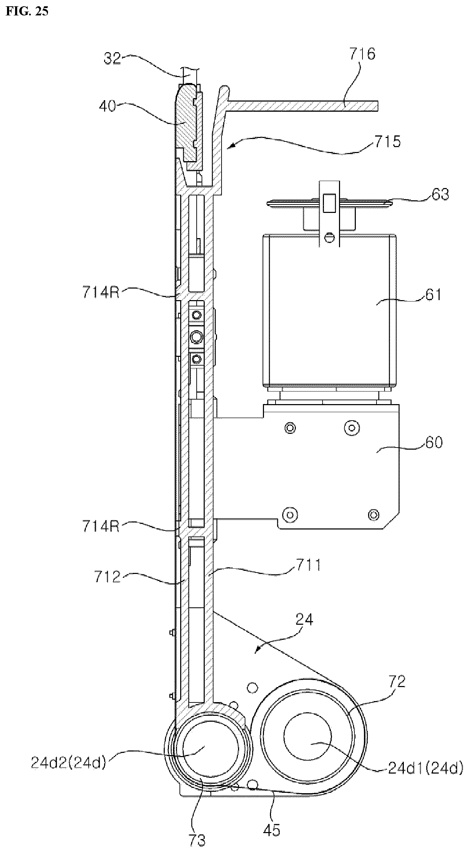

Referring to FIGS. 24 and 25 together with FIG. 21, the pulley mount 79 may cover the first cutout portion 712b of the mount part 712a. The pulley mount 79 may be fixed to the mount part 712a while covering the first cut portion 712b. The drive pulley 31 may be positioned at the first cut portion 712b. The drive pulley 31 may be coupled to the pulley mount 79 at the first cut portion 712b and rotate.

The belt 32 may be wound around the drive pulley 31. The bar 40 may be fixed to the belt 32, and may move in the up-down direction by the belt 32. When the drive pulley 31 rotates, and the belt 32 engaged with the drive pulley 31 moves, the bar 40 may move in the up-down direction.

The sub pulley 50 may push the belt 32. There may be a plurality of sub pulleys 50, and the plurality of sub pulleys 51, 52 may adjust the tension of the belt 32 by pushing the belt 32.

The joint 62a may provide a rotation shaft of the drive pulley 31. The gear box 62 may be positioned at the rear of the drive pulley 31, and the joint 62a may connect the drive pulley 31 and the gear box 62. The motor 61 may provide rotational power to the gear box 62.

Accordingly, the belt 32 that is wound around the drive pulley 31 and/or the sub pulley 50 and fixed to the bar 40 may be aligned without being tilted or twisted in the up-down direction. The belt 32 may transmit the force provided from the drive pulley 31 to the bar without loss while moving in the vertical direction. In addition, it is possible to prevent uneven wear due to distortion of the belt 32. In addition, it is possible to prevent damage to the belt 32 due to uneven wear of the belt 32.

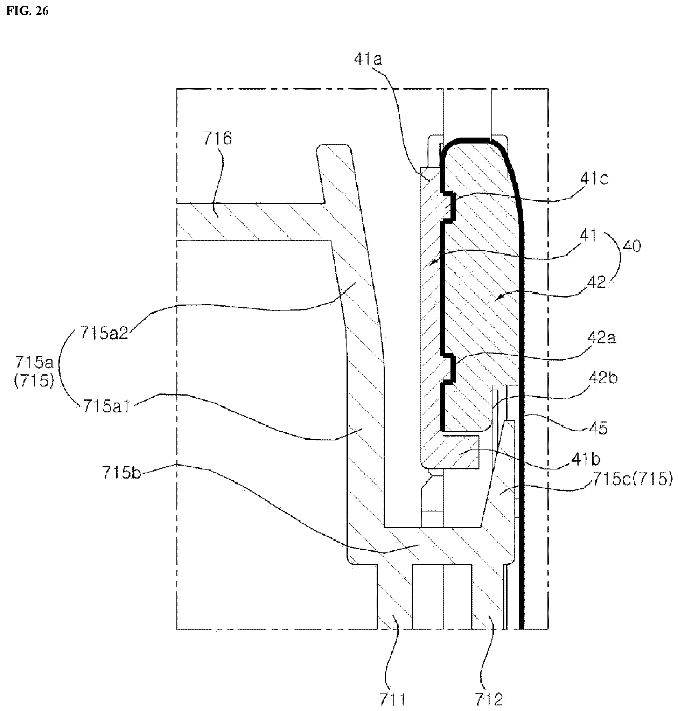

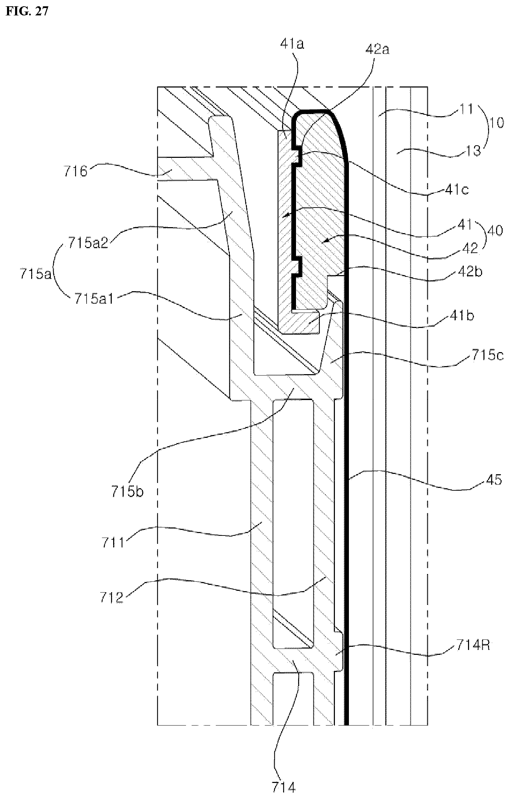

Referring to FIGS. 26 and 27, the bar 40 may include a first piece 41 and a second piece 42. The first piece 41 may be coupled to the second piece 42. The first piece 41 may include a first part 41a and a second part 41b. The first part 41a may be in the shape of an elongated plate bar. The second part 41b may form a wall at the lower side of the first part 41a while extending in the thickness direction of the first part 41a. The fixing rib 41c may be formed on one surface of the first part 41a. The fixing rib 41c may be elongated in the length direction of the first part 41a. There may be a plurality of fixing ribs 41c. The plurality of fixing ribs 41c may be disposed spaced apart from each other by a certain distance.

The second piece 42 may be a plate bar shape that extends to a length corresponding to the first part 41a of the first piece 41. The rib groove 42a may be formed to extend from one side of the second piece 42 in the length direction of the second piece 42. There may be a plurality of rib grooves 42a, and the plurality of rib grooves 42a may be disposed on one surface of the second piece 42a in correspondence with the plurality of fixing ribs 41c.

The light shielding film 45 may be wound around the bar 40. The light shielding film 45 may cover the outer surface of the second piece 42, may be wound around the upper edge of the rounded second piece 42, and may be inserted between the first piece 41 and the second piece 42. The light shielding film 45 may be in contact with the first piece 41 and the second piece 42. The light shielding film 45 may be positioned between the fixing rib 41c and the rib groove 42a. The fixing rib 41c may hold the light shielding film 45 while being inserted into the rib groove 42a. The light shielding film 45 may provide a taut tension to the light shielding film 45 while being wound around the upper edge of the rounded second piece 42.

The second piece 42 of the bar 40 may have a support groove 42b. The support groove 42b may be formed by deleting or sinking the lower side of the second piece 42 into the inside of the second piece 42. The support groove 42b may be opposite to the first part 41a of the first piece 41 with respect to the light shielding film 45.

The front supporter 715c of the bar supporter 715 may be inserted into the support groove 42b of the bar 40. The bar 40 may be lowered until the support groove 42b touches the front supporter 715c. As the bar 40 is lowered, the lowering of the bar 40 may be stopped when the support groove 42b of the bar 40 touches the front supporter 715c. If the left and right levels of the bar 40 are not aligned, the left and right levels of the bar 40 may be reset as the bar 40 is seated on the front supporter 715c.

For example, the bar 40 may be raised or lowered when the horizontal level of the bar 40 is not aligned. If the light shielding film 45 is raised or lowered while the horizontal level of the bar 40 is not aligned, the light shielding film 45 may not be maintained flat, and the light shielding film 45 may damage the display 10 by rubbing against the rear surface of the display 10. In addition, the static electricity generated when the light shielding film 45 rubs against the rear surface of the display 10 may interfere with the operation of the light shielding film 45.

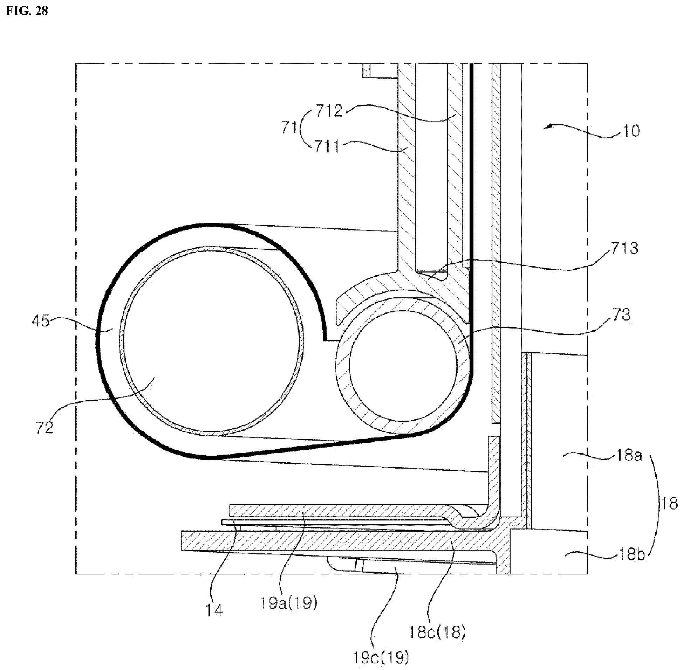

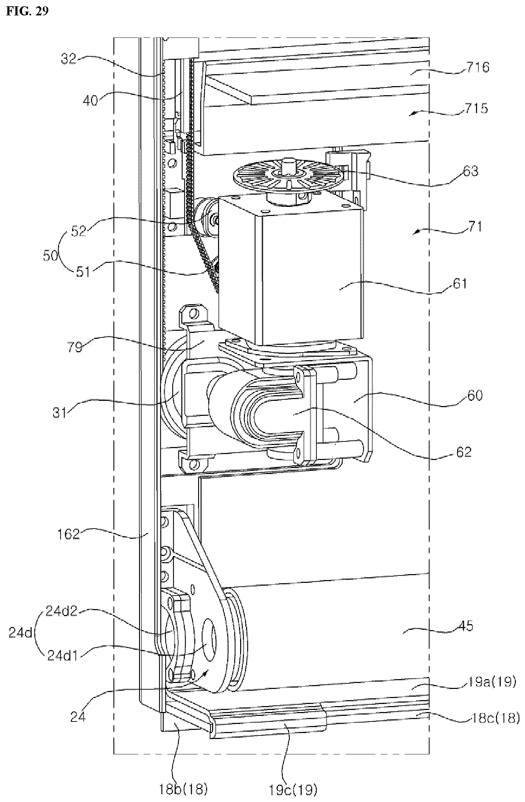

Referring to FIGS. 28 and 29, the sub roller 73 may be positioned below the roller cover 713. The roller cover 713 may cover the upper arc of the sub roller 73. The roller cover 713 may be spaced apart from the sub roller 73. The main roller 72 may be positioned on the lower rear side of the housing frame 71 while being adjacent to the sub roller 73. The light shielding film 45 may be wound around the main roller 72, and supported or spread by the sub roller 73. The light shielding film 45 may be unwound from the main roller 72, may be wound around a part of the sub roller 73, and cover the front part 712 of the housing frame 71. The light shielding film 45 may be coupled or fixed to the bar 40. The bar 40 may be positioned on the bar supporter 715. When the bar 40 is positioned on the bar supporter 715, the bar 40 may be positioned at the bottom dead center.

The display 10 may be opposite to the housing frame 71 with respect to the light shielding film 45. The display 10 may face the light shielding film 45 and/or the front part 712 of the housing frame 71. The light shielding film 45 may cover the rear surface of the display 10. The bar 40 may be positioned adjacent to the rear surface of the display 10.

The main roller 72 and/or the sub roller 73 may be positioned on the lower frame 18. The main roller 72 and/or the sub roller 73 may be spaced from the lower frame 18 and/or the PCB cover 19. The vertical portion 18a of the lower frame 18 may cover the front of the sub roller 73. The light shielding film 45, which is unwound from the main roller 72 and wound around the sub roller 73, may be covered by the vertical portion 18a of the lower frame 18.

The driving force provided by the motor 61 may be transmitted to the drive pulley 31 through the gear box 62. The drive pulley 31 may rotate on the pulley mount 79. As the drive pulley 31 rotates, the belt 32 moves in the up-down direction, and the belt 32 may maintain a certain tension by the sub pulley 50.

The lower frame 18 to which the PCB cover 19 is coupled may be positioned below the housing frame 71. The main roller 72 and the sub roller 73 may be positioned on the lower frame 18, and may be positioned at the rear of the housing frame 71. The light shielding film 45 may be wound around and unwound from the main roller 72, and guided by the sub roller 73 to cover the front surface of the housing frame 71.

The distal end of the light shielding film 45 may be fixed to the bar 40. As the belt 32 fixed to one end of the bar 40 moves, the bar 40 may move in the up-down direction. As the bar 40 moves, the light shielding film 45 may cover the rear surface of the display 10. The bar 40 is positioned at the rear of the rear surface of the display 10, and may move in the up-down direction of the display 10.

Accordingly, the belt 32 which is wound around the drive pulley 31 and/or the sub pulley 50 and is fixed to the bar 40 may be aligned without being tilted or twisted in the up-down direction. As the belt 32 moves in the vertical direction, the force provided from the drive pulley 31 may be transmitted to the bar without loss. In addition, uneven wear due to the twist of the belt 32 may be prevented. In addition, damage to the belt 32 due to uneven wear of the belt 32 may be prevented.

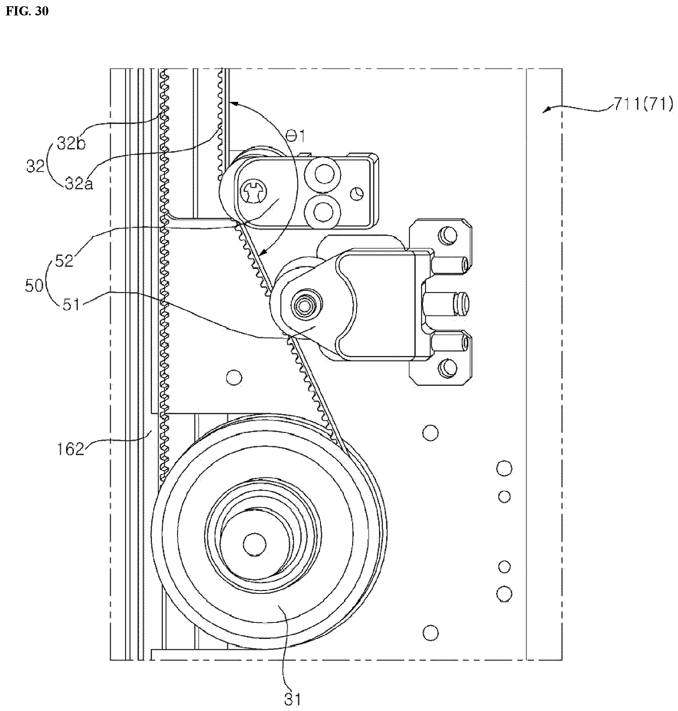

Referring to FIG. 30, the sub pulley 50 may be a tensioner 50. The sub pulley 50 may be coupled or fixed to the rear surface of the rear part 711 of the housing frame 71. The sub pulley 50 may be positioned above the drive pulley 31, and may push the belt 32. The belt 32 may maintain a certain tension by the sub pulley 50.

The sub pulley 50 may be plural 51, 52. The first sub pulley 51 may be positioned between the drive pulley 31 and the second sub pulley 52. The second sub pulley 52 may be positioned between the first sub pulley 51 and the bar 40 (see FIG. 29). The sub pulley 50 may be referred to as an idle roller 50.

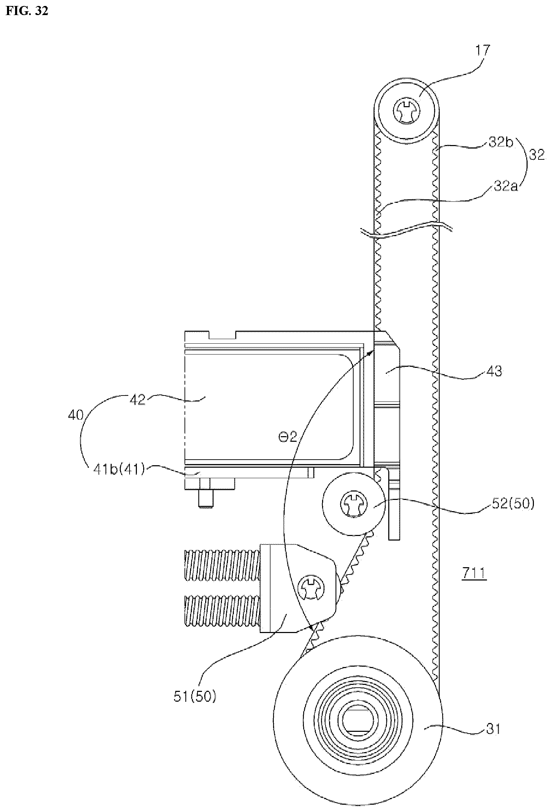

The belt 32 may be divided into an inner belt 32a and an outer belt 32b. The inner belt 32a may be a portion where the bar 40 (see FIG. 29) is fixed between the upper pulley 17 (see FIG. 11) and the drive pulley 31. The inner belt 32a may be fixed to the bar 40 (see FIG. 29) by the belt fixer 43 (see FIG. 32). The outer belt 32b may be a portion facing the vertical fixer 162 at between the upper pulley 17 and the drive pulley 31. The outer belt 32b may be positioned between the vertical fixer 162 and the inner belt 32a.

In the drive in which the inner belt 32a raises the bar 40 (see FIG. 29), a large tension may be applied to the outer belt 32b, as the load is applied to the outer belt 32b. At this time, the inner belt 32a positioned between the upper pulley 17 (see FIG. 11) and the bar 40 (see FIG. 29) may be applied with the same load as the outer belt 32b. Accordingly, the bar 40 (see FIG. 29) and the light shielding film 45 (see FIG. 29) may rise. On the other hand, the inner belt 32a positioned between the bar 40 (see FIG. 29) and the drive pulley 31 may be loosely wound around the drive pulley 31. The loosened inner belt 32a may be pushed by the sub pulley 50. For example, the inner belt 32a positioned between the bar 40 (see FIG. 29) and the second sub pulley 52 may form an angle (theta 1) of 153 to 155 degrees with respect to the inner belt 32a positioned between the second sub pulley 52 and the drive pulley 31.

For example, when the drive pulley 31 and the belt 32 are gear-coupled and the drive pulley 31 rotates counterclockwise to transmit power to the belt 32, the outer belt 32b wound around the drive pulley 31 and the upper pulley 17 (see FIG. 11) may be taut. At the same time, the inner belt 32a positioned between the bar 40 (see FIG. 29) and the upper pulley 17 (see FIG. 11) may be equally taut as the outer belt 32b. At this time, the inner belt 32a positioned between the bar 40 (see FIG. 29) and the drive pulley 31 may be loosened. Therefore, the sub pulleys 50, which push the inner belt 32a positioned between the bar 40 (see FIG. 29) and the drive pulley 31, may maintain the tension of the belt 32 uniformly as a whole.

Accordingly, the belt 32 may be prevented from being separated from the drive pulley 31, and noise and/or vibration generated by friction between the belt 32 and the drive pulley 31, or generated by recoupling after separation may be suppressed. In addition, the belt 32 may be prevented from being stretched due to the use of the belt 32 for a long time.

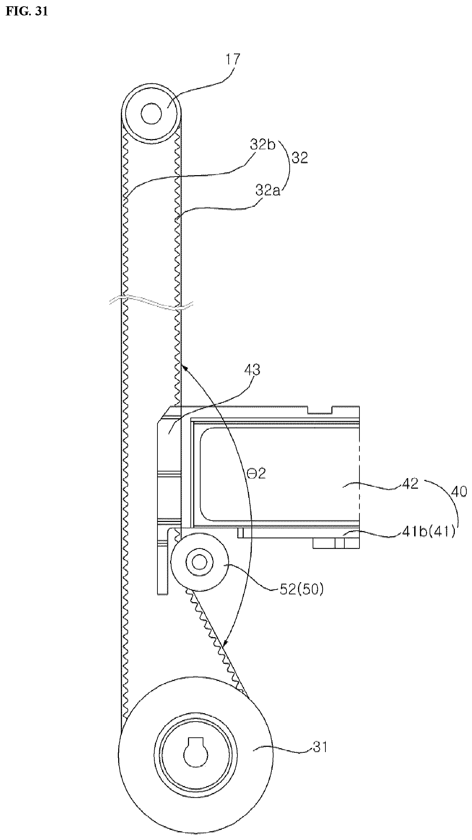

Referring to FIGS. 31 and 32, the sub pulley 50 may be a tensioner 50. The sub pulley 50 may be coupled or fixed to the rear surface of the rear part 711 of the housing frame 71. The sub pulley 50 may be positioned above the drive pulley 31, and may push the belt 32. The belt 32 may maintain a certain tension by the sub pulley 50.

The sub pulley 50 may be plural 51, 52. The first sub pulley 51 may be positioned between the drive pulley 31 and the second sub pulley 52. The second sub pulley 52 may be positioned between the first sub pulley 51 and the bar 40.

The belt 32 may be divided into an inner belt 32a and an outer belt 32b. The inner belt 32a may be a portion positioned between the upper pulley 17 and the drive pulley 31. The inner belt 32a may be fixed to the bar 40 by a belt fixer 43. The outer belt 32b may be a portion positioned between the upper pulley 17 and the drive pulley 31.

In the drive in which the inner belt 32a raises the bar 40, a large tension may be applied to the outer belt 32b, as a load is applied to the outer belt 32b. At this time, the inner belt 32a positioned between the upper pulley 17 and the bar 40 may be applied with the same load as the outer belt 32b. Accordingly, the bar 40 and the light shielding film 45 (see FIG. 29) may rise. On the other hand, the inner belt 32a positioned between the bar 40 and the drive pulley 31 may be loosely wound around the drive pulley 31. The loosened inner belt 32a may be pushed by the sub pulley 50. For example, the inner belt 32a positioned between the bar 40 and the second sub pulley 52 may form an angle theta 2 of 150 to 152 degrees with respect to the inner belt 32a positioned between the second sub pulley 52 and the drive pulley 31.

For example, when the drive pulley 31 and the belt 32 are gear-coupled and the drive pulley 31 rotates counterclockwise (see FIG. 31) and clockwise (see FIG. 32) to transmit power to the belt 32, the outer belt 32b wound around the drive pulley 31 and the upper pulley 17 may be taut. At the same time, the inner belt 32a positioned between the bar 40 and the upper pulley 17 may be equally taut as the outer belt 32b. At this time, the inner belt 32a positioned between the bar 40 and the drive pulley 31 may be loosened. Therefore, the sub pulleys 50 that push the inner belt 32a positioned between the bar 40 and the drive pulley 31 may maintain the tension of the belt 32 uniformly as a whole.

Accordingly, the belt 32 may be prevented from being separated from the drive pulley 31, and noise and/or vibration generated by friction between the belt 32 and the drive pulley 31, or generated by recoupling after separation may be suppressed. In addition, the belt 32 may be prevented from being stretched due to the use of the belt 32 for a long time.

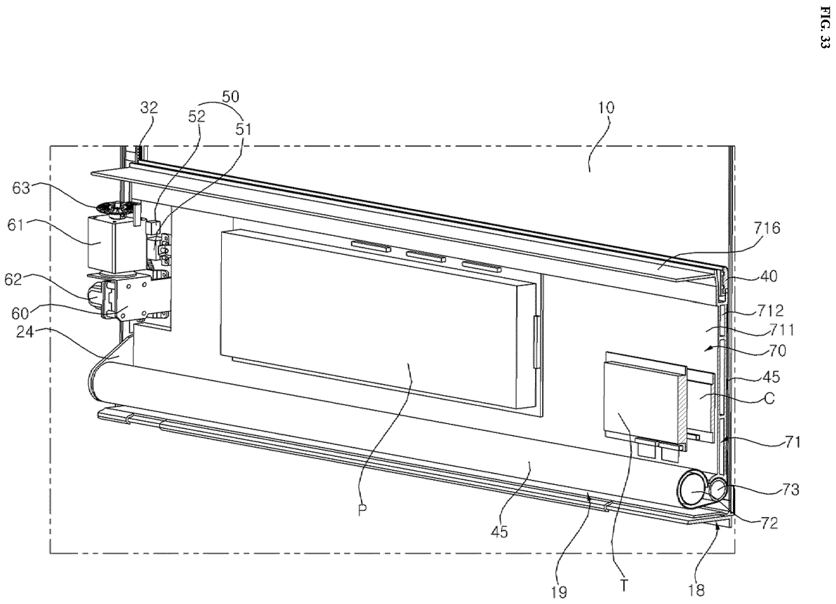

Referring to FIG. 33, the display 10 may be opposite to the housing frame 71 with respect to the light shielding film 45. The display 10 may face the light shielding film 45 and/or the front part 712 of the housing frame 71. The light shielding film 45 may cover the rear surface of the display 10. The bar 40 may be positioned adjacent to the rear surface of the display 10.

The main roller 72 and/or the sub roller 73 may be positioned on the lower frame 18. The main roller 72 and/or the sub roller 73 may be spaced from the lower frame 18 and/or the PCB cover 19. The light shielding film 45 may be unwound from the main roller 72 and wound around the sub roller 73.

The driving force provided by the motor 61 may be transmitted to the drive pulley 31 (see FIG. 29) through the gear box 62. As the drive pulley 31 (see FIG. 29) rotates, the belt 32 moves in the up-down direction, and the belt 32 may maintain a certain tension by the sub pulley 50.

The lower frame 18 to which the PCB cover 19 is coupled may be positioned below the housing frame 71. The main roller 72 and the sub roller 73 may be positioned on the lower frame 18, and may be positioned below and/or behind the housing frame 71. The light shielding film 45 may be wound around and unwound from the main roller 72, and may be guided by the sub roller 73 to cover the front surface of the housing frame 71.

The distal end of the light shielding film 45 may be fixed to the bar 40. As the belt 32 fixed to one end of the bar 40 moves, the bar 40 may move in the up-down direction. As the bar 40 moves, the light shielding film 45 may cover the rear surface of the display 10. The bar 40 may be positioned behind the rear surface of the display 10, and may move in the up-down direction of the display 10.

The control board P, T, C may be coupled or fixed to the rear surface of the rear part 711 of the housing frame 71. There may be a plurality of control boards P, T, C. A plurality of control boards P, T, C may include a power supply P, a T-CON board T, and/or a main board C. Heat generated from the control board P, T, C may be transferred to the rear part 711 of the housing frame 71. Since the front part 712 and the rear part 711 of the housing frame 71 are separated from each other, the heat transferred to the rear part 711 of the housing frame 71 may be blocked from being transferred to the display 10 via the front part 712. Accordingly, it is possible to prevent the heat generated from the control board P, T, C from deteriorating the performance of the display 10.

Referring to FIGS. 1 and 33, a display device includes: a display panel which displays an image and has light transmission properties; a transparent panel facing the display panel; a side frame which extends along a lateral side of the display panel, and is coupled to the transparent panel; a belt which is embedded in the side frame, and moves along a length direction of the side frame; a bar which extends in a direction intersecting with the side frame, and has one end fixed to the belt; a roller which is adjacent to a lower side connected to the lateral side of the display panel, and extends along the lower side of the display panel and is rotatable; a light shielding film which has one end fixed to the bar, has the other end coupled to the roller, and is wound around or unwound from the roller when the bar moves; a rear frame which is positioned opposite to the transparent panel with respect to the light shielding film; an upper pulley which is positioned above the side frame, and around which the belt is wound; a drive pulley which is mounted on the rear frame, faces the light shielding film, rotates about an axis that is a thickness direction of the light shielding film, and around which the belt is wound; and a sub pulley which is positioned between the drive pulley and the bar, is mounted on the rear frame while being adjacent to the drive pulley, and pushes the belt.

The rear frame includes: a front part facing the light shielding film in a plate shape; a rear part positioned opposite to the light shielding film with respect to the front part; and an inner rib which is positioned between the front part and the rear part, and connects the front part and the rear part, and the sub pulley is coupled to a rear surface of the rear part.

The rear frame includes: a front part facing the light shielding film in a plate shape; a rear part which is positioned opposite to the light shielding film with respect to the front part, and spaced apart from the front part; and an outer rib protruding from an outer surface of the front part, and the sub pulley is coupled to a rear surface of the rear part.

The rear frame further includes an inner rib which is positioned between the front part and the rear part, and connects the front part and the rear part, and the inner rib is positioned in correspondence with the outer rib.

The rear frame further includes a mount part formed on an inner surface of the front part where the rear part is cut and exposed, and the drive pulley and the sub pulley are mounted on the mount part.

The rear frame further includes a pulley mount coupled to the mount part and to which the drive pulley is rotatably coupled, and the drive pulley is positioned between the pulley mount and the light shielding film.

The rear frame further includes a roller cover which is positioned between the roller and at least one of the front part and the rear part, and forms a lower portion of the rear frame.

The roller includes: a sub roller positioned below the roller cover; and a main roller adjacent to the sub roller, and the light shielding film is wound around or unwound from the main roller, and supported by the sub roller.

The sub pulley includes: a first sub pulley positioned between the drive pulley and the bar; and a second sub pulley positioned between the first sub pulley and the bar, and the belt comes in contact with at least one of the first sub pulley and the second sub pulley.

The belt includes: an outer belt which is positioned between the drive pulley and the upper pulley, and faces the side frame; and an inner belt which is positioned between the drive pulley and the upper pulley, and to which the bar is fixed, and the inner belt, which is divided into both sides with respect to the sub pulley, forms an obtuse angle.

The display device further includes a control board coupled to a rear surface of the rear part of the rear frame, in which the control board includes at least one of a power supply, a T-CON board, and a main board.

The display device further includes a gear box which is connected to a shaft of the drive pulley, and positioned behind the rear frame; and a motor which provides a rotational force to the gear box, and is positioned behind the rear frame.

The drive pulley maintains a constant gap from the light shielding film.

The display device further includes a lower frame which is positioned below the display panel, and supports the transparent panel, and the display panel further includes a source PCB which is electrically connected to the display panel, and positioned on the lower frame.

The lower frame includes: a horizontal portion on which the source PCB is placed; a vertical portion which is connected to the horizontal portion, and covers a front surface adjacent to a lower side of the transparent panel; and a PCB cover which is positioned opposite to the horizontal portion of the lower frame with respect to the source PCB, and covers the source PCB, in which the PCB cover is fixed to the lower frame.

The effects of the display device according to the present disclosure are described as follows.

According to at least one of the embodiments of the present disclosure, a display device having a transparent display panel can be provided.

According to at least one of the embodiments of the present disclosure, a structure and a driving mechanism for opening and closing the rear surface of the transparent display panel can be provided.

According to at least one of the embodiments of the present disclosure, a frame structure in which a transparent display panel and a light shielding film are coupled can be provided.

According to at least one of the embodiments of the present disclosure, a frame structure that maintains the left and right levels of a light shielding film to be equal and supports the bottom dead center of the light shielding film can be provided.

According to at least one of the embodiments of the present disclosure, a frame structure that covers a roller around which a light shielding film is wound or that support the light shielding film can be provided.

According to at least one of the embodiments of the present disclosure, a mechanism that can increase the service life of a belt can be provided.

Certain embodiments or other embodiments of the invention described above are not mutually exclusive or distinct from each other. Any or all elements of the embodiments of the invention described above may be combined or coupled to each other in configuration or function.

For example, a configuration "A" described in one embodiment of the invention and the drawings and a configuration "B" described in another embodiment of the invention and the drawings may be coupled to each other. Namely, although the combination between the configurations is not directly described, the combination is possible except in the case where it is described that the combination is impossible.

Although embodiments have been described with reference to a number of illustrative embodiments thereof, it should be understood that numerous other modifications and embodiments can be devised by those skilled in the art that will fall within the scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A display device comprising:
a display panel (11) which displays an image and has light transmission properties;
a transparent panel (13) facing the display panel (11);
a side frame (20) which extends along a lateral side of the display panel (11), and is coupled to the transparent panel (13);
a belt (32) which is embedded in the side frame (20), and moves along a length direction of the side frame (20);
a bar (40) which extends in a direction intersecting with the side frame (20), and has one end fixed to the belt (32);
a roller (72,73) which is adjacent to a lower side connected to the lateral side of the display panel (11), and extends along the lower side of the display panel (11) and is rotatable;
a light shielding film (45) which has one end fixed to the bar (40), has the other end coupled to the roller (72,73), and is wound around or unwound from the roller (72,73) when the bar (40) moves;
a rear frame (71) which is positioned opposite to the transparent panel (13) with respect to the light shielding film (45);
an upper pulley (17) which is positioned above the side frame (20), and around which the belt (32) is wound;
a drive pulley (31) which is mounted on the rear frame (71), faces the light shielding film (45), rotates about an axis that is a thickness direction of the light shielding film (45), and around which the belt (32) is wound; and
a sub pulley (50,51,52) which is positioned between the drive pulley (31) and the bar (40), is mounted on the rear frame (71) while being adjacent to the drive pulley (31), and pushes the belt (32).

2. The display device of claim 1, wherein the rear frame (71) comprises:
a front part (712) facing the light shielding film (45) in a plate shape;
a rear part (711) positioned opposite to the light shielding film (45) with respect to the front part (712); and
an inner rib (714) which is positioned between the front part (712) and the rear part (711), and connects the front part (712) and the rear part (711),
wherein the sub pulley (50) is coupled to a rear surface of the rear part (711).

3. The display device of claim 1 or 2, wherein the rear frame (71) comprises:
a front part (712) facing the light shielding film (45) in a plate shape;
a rear part (711) which is positioned opposite to the light shielding film (45) with respect to the front part (712), and spaced apart from the front part (712); and
an outer rib (714R) protruding from an outer surface of the front part (712),
wherein the sub pulley (50) is coupled to a rear surface of the rear part (711).

4. The display device of claim 3, wherein the rear frame (71) further comprises:
an inner rib (714) which is positioned between the front part (712) and the rear part (711), and connects the front part (712) and the rear part (711),
wherein the inner rib (714) is positioned in correspondence with the outer rib (714R).

5. The display device of one of claims 2 to 4, when being dependent on claim 2, wherein the rear frame (71) further comprises:
a mount part (712a) formed on an inner surface of the front part (712) where the rear part (711) is cut and exposed,
wherein the drive pulley (31) and the sub pulley (50) are mounted on the mount part (712a).

6. The display device of claim 5, wherein the rear frame (71) further comprises:
a pulley mount (79) coupled to the mount part (712a), and to which the drive pulley (31) is rotatably coupled,
wherein the drive pulley (31) is positioned between the pulley mount (79) and the light shielding film (45).

7. The display device of one of claims 2 to 6, when being dependent on claim 2, wherein the rear frame (71) further comprises:
a roller cover (713) which is positioned between the roller (72,73) and at least one of the front part (712) and the rear part (711), and forms a lower portion of the rear frame (71).

8. The display device of claim 7, wherein the roller (72,73) comprises:
a sub roller (73) positioned below the roller cover (713); and
a main roller (72) adjacent to the sub roller (73),
wherein the light shielding film (45) is wound around or unwound from the main roller (72), and supported by the sub roller (73).

9. The display device of one of claims 1 to 8, wherein the sub pulley (50) comprises:
a first sub pulley (51) positioned between the drive pulley (31) and the bar (40); and
a second sub pulley (52) positioned between the first sub pulley (51) and the bar (40),
wherein the belt (32) comes in contact with at least one of the first sub pulley (51) and the second sub pulley (52).

10. The display device of one of claims 1 to 9, wherein the belt (32) comprises:
an outer belt (32b) which is positioned between the drive pulley (31) and the upper pulley (17), and faces the side frame (20); and
an inner belt (32a) which is positioned between the drive pulley (31) and the upper pulley (17), and to which the bar (40) is fixed,
wherein the inner belt (32a), which is divided into both sides with respect to the sub pulley (50), forms an obtuse angle.

11. The display device of one of claims 2 to 10, when being dependent on claim 2, further comprising:
a control board (P,T,C) coupled to a rear surface of the rear part (711) of the rear frame (71),
wherein the control board (P,T,C) comprises at least one of a power supply (P), a T-CON board (T), and a main board (C).

12. The display device of one of claims 1 to 11, further comprising:
a gear box (62) which is connected to a shaft (31a) of the drive pulley (31), and positioned behind the rear frame (71); and
a motor (61) which provides a rotational force to the gear box (62), and is positioned behind the rear frame (71).

13. The display device of one of claims 1 to 12, wherein the drive pulley (31) maintains a constant gap (G) from the light shielding film (45).

14. The display device of one of claims 1 to 13, further comprising:
a lower frame (18) which is positioned below the display panel (11), and supports the transparent panel (13),
wherein the display panel (11) further comprises a source PCB (14) which is electrically connected to the display panel (11), and positioned on the lower frame (18).

15. The display device of claim 14, wherein the lower frame (18) comprises:
a horizontal portion (18c) on which the source PCB (14) is placed;
a vertical portion (18a) which is connected to the horizontal portion (18c), and covers a front surface adjacent to a lower side of the transparent panel (13); and
a PCB cover (19) which is positioned opposite to the horizontal portion of the lower frame (18) with respect to the source PCB (14), and covers the source PCB (14),
wherein the PCB cover (19) is fixed to the lower frame (18).
